# EUROPÄISCHE PATENTSCHRIFT

(11) **EP 3 873 778 B1**
(45) Veröffentlichungstag und Bekanntmachung des Hinweises auf die Patenterteilung: **20.12.2023**
(21) Anmeldenummer: 19789605.3
(22) Anmeldetag: 09.10.2019
(51) Int. Cl.: B60Q 1/00, H01L 25/16, H05B 45/00

(54) **VERFAHREN ZUM HERSTELLEN EINER LICHTQUELLENANORDNUNG UND NACH EINEM SOLCHEN VERFAHREN HERGESTELLTE LICHTQUELLENANORDNUNG**
METHOD FOR MANUFACTURING A LIGHT SOURCE ARRANGEMENT AND LIGHT SOURCE ARRANGEMENT MANUFACTURED ACCORDING TO SUCH A METHOD
PROCÉDÉ DE FABRICATION D'UN ENSEMBLE DE SOURCES LUMINEUSES ET ENSEMBLE DE SOURCES LUMINEUSES FABRIQUÉ SELON UN TEL PROCÉDÉ

(30) Priorität: 30.10.2018 DE 102018127115
(43) Veröffentlichungstag der Anmeldung: 08.09.2021
(73) Patentinhaber: Marelli Automotive Lighting Reutlingen (Germany) GmbH, 72762 Reutlingen (DE)
(72) Erfinder: LEIPERT, Anna, 72762 Reutlingen (DE)
(74) Vertreter: Wörz, Volker Alfred
(86) Internationale Anmeldenummer: PCT/EP2019/077327
(87) Internationale Veröffentlichungsnummer: WO 2020/088901

(56) Entgegenhaltungen:
- EP-A1- 2 437 581
- EP-A2- 1 843 394
- DE-A1-102008 033 176
- DE-A1-102009 051 866
- DE-U1-202016 100 243
- US-A1- 2007 085 096
- US-A1- 2010 237 780

## Beschreibung

Die Erfindung betrifft ein Verfahren zum Herstellen einer Lichtquellenanordnung für eine Kraftfahrzeugbeleuchtungseinrichtung, mit mindestens einer Leuchtdiode zum Erzeugen von Licht und einem Widerstandselement zum Vorgeben von optischen und/oder elektrischen Eigenschaften der Leuchtdiode an ein Steuergerät zum Steuern oder Regeln der Lichtquellenanordnung.

Die Erfindung betrifft außerdem eine nach einem solchen Verfahren hergestellte Lichtquellenanordnung für eine Kraftfahrzeugbeleuchtungseinrichtung. Produktionsprozesse zur Herstellung von Leuchtdioden unterliegen oftmals erheblichen Schwankungen, was zu relativ großen Toleranzen von optischen und/oder elektrischen Eigenschaften der hergestellten Leuchtdioden führt. Dies hat insbesondere zur Folge, dass verschiedene Leuchtdioden des gleichen Typs bei identischer elektrischer Ansteuerung einen unterschiedlichen Lichtstrom erzeugen, also für einen Betrachter unterschiedlich hell erscheinen. Je nach dem von Leuchtdioden tatsächlich abgegebenem Lichtstrom sind sie verschiedenen Lichtstromklassen (sog. Bins) zugeordnet. Die unterschiedlichen Helligkeiten wirken sich insbesondere beim Einsatz der Leuchtdioden im Bereich der Kraftfahrzeugbeleuchtung nachteilig aus, weil aufgrund dieser Toleranzen der Leuchtdioden oftmals relativ eng vorgegebene Vorschriften an die von einer Beleuchtungseinrichtung erzeugte Lichtverteilung nicht sicher für alle innerhalb einer Großserie hergestellten Beleuchtungseinrichtungen eingehalten werden können. Weist eine Kraftfahrzeugbeleuchtungseinrichtung eine Lichtquellenanordnung mit mehreren Leuchtdioden oder mehrere Lichtquellenanordnungen mit mindestens einer Leuchtdiode auf, so kann es aufgrund der Toleranzen der verwendeten Leuchtdioden dazu kommen, dass die Leuchtdioden unterschiedlich hell leuchten, was für einen Nutzer eines Kraftfahrzeugs aber auch für externe Betrachter in der Regel nicht akzeptabel ist.

Aus der DE 101 46 094 A1 ist es bekannt, in einem Steuergerät für eine Beleuchtungsvorrichtung Informationen über die optischen und/oder elektrischen Eigenschaften der Leuchtdiode abzulegen, so dass das Steuergerät durch entsprechende Ansteuerung der Leuchtdioden diese Toleranzen ausgleichen kann.

Außerdem ist es allgemein bekannt, an der Lichtquellenanordnung einen Abgleichwiderstand vorzusehen, dessen Widerstandswert die optischen und/oder elektrischen Eigenschaften einer SMD-Leuchtdiode charakterisiert. Dazu müssen vorab verschiedene Abgleichwiderstände den verschiedenen Lichtstromklassen der SMD-Leuchtdioden zugeordnet werden. Bei der Herstellung der allgemein bekannten Lichtquellenanordnung werden zunächst die Eigenschaften der auf dem Schaltungsträger zu montierenden SMD-Leuchtdiode durch geeignete Messungen erfasst, so dass die SMD-Leuchtdiode in eine bestimmte Lichtstromklasse (bzw. Bin) eingeordnet werden kann. Anschließend wird in Abhängigkeit von den erfassten Eigenschaften ein Abgleichwiderstand mit einem bestimmten Widerstandswert ausgewählt, welcher der Lichtstromklasse bzw. dem Bin der SMD-Leuchtdiode zugeordnet ist. Schließlich werden die SMD-Leuchtdiode und der Abgleichwiderstand gemeinsam in einem SMD-Prozess auf dem Schaltungsträger angebracht und elektrisch kontaktiert. Dies ist bei gleichzeitiger Bestückung des Abgleichwiderstands mit der SMD-Leuchtdiode relativ leicht möglich.

Ein Problem kann sich jedoch ergeben, wenn die SMD-Leuchtdiode in einem nachgelagerten Prozess an den Schaltungsträger angebunden wird. In diesem Fall müssen immer genug mit Abgleichwiderständen unterschiedlicher Widerstandswerte bestückte Schaltungsträger vorab produziert und vorgehalten werden, um dann innerhalb der relativ kurzen Taktzeiten einen Schaltungsträger mit dem gewünschten Widerstandswert des Abgleichwiderstands auswählen zu können, der der ermittelten Lichtstromklasse einer zu montierenden Leuchtdiode entspricht. Ferner sind die bekannten Verfahren nicht für die Verwendung von sog. Top Mount Leuchtdioden geeignet.

Schließlich sind aus der DE 10 2009 051 866 A1 und DE 10 2008 033 176 A1 ein Verfahren zum Herstellen einer Lichtquellenanordnung mit mindestens einer SMD-Leuchtdiode und eine nach dem Verfahren hergestellte Lichtquellenanordnung bekannt, wobei die SMD-Leuchtdiode und das Widerstandselement direkt auf einem Schaltungsträger der Lichtquellenanordnung angeordnet und dann der Widerstandswert des Widerstandselements in Abhängigkeit von den zuvor erfassten Eigenschaften der SMD-Leuchtdiode abgeglichen wird.

Aufgabe der Erfindung ist es, ein Verfahren zum Herstellen einer Lichtquellenanordnung anzugeben, mit dem auf einfache und kostengünstige Weise eine zuverlässig arbeitende abgeglichene Lichtquellenanordnung mit mindestens einer Top Mount Leuchtdiode hergestellt werden kann.

Diese Aufgabe wird durch ein Verfahren mit den Merkmalen des Anspruchs 1 gelöst.

Im Rahmen des Verfahrens wird mindestens eine Top Mount Leuchtdiode auf einem Kühlkörper befestigt und das Widerstandselement direkt auf einem Schaltungsträger angeordnet, d.h. befestigt und elektrisch kontaktiert. Bei einer Top Mount (oder Top Contact) Leuchtdiode handelt es sich um ein sog. Submount, das nicht über SMD-Techniken angebunden werden kann. Das Submount umfasst einen oder mehrere LED-Chips zum Emittieren von Licht einer ersten Wellenlänge und elektrische Anschlüsse, bspw. in Form von Bonding-Pads, an einer Oberseite des Submounts, sowie ein vollflächiges Wärmespreizelement an der Unterseite des Submounts. Wahlweise kann das Submount auch einen Konverter, der bspw. Phosphor umfasst, zum Konvertieren zumindest eines Teils des von den LED-Chips emittierten Lichts (z.B. blaues Licht) in Licht einer anderen Wellenlänge (z.B. gelbes Licht) aufweisen, sodass eine additive Farbmischung des Lichts der ersten und der anderen Wellenlänge Licht einer anderen Farbe (z.B. weißes Licht) ergibt. Das Submount kann wahlweise auch eine Kapselung aus einem Harz- oder Kunststoffmaterial, vorzugsweise aus einem transparenten Material, zum Schutz der elektrischen Bauteile des Submounts aufweisen. Die Top Mount Leuchtdioden werden mit ihrem Wärmespreizelement unmittelbar auf einem Kühlkörper befestigt. Dadurch ergibt sich ein besonders guter Wärmeübergang zwischen den LED-Chips und dem Kühlkörper bzw. der Umgebung.

Nach dem Anordnen des Widerstandselements auf dem Schaltungsträger wird ein Widerstandswert des Widerstandselements in Abhängigkeit von den zuvor ermittelten Eigenschaften der Top Mount Leuchtdiode abgeglichen. Unter Abgleichen ist ein Einstellen des Widerstandswerts auf eine bestimmte Größe zu verstehen. Die Eigenschaften der Leuchtdiode umfassen vorzugsweise elektrische und/oder optische Eigenschaften. Beispielsweise können die Eigenschaften einen Lichtstrom und/oder eine Farbe des von der Leuchtdiode abgegebenen Lichts, eine Vorwärtsspannung der Leuchtdiode und/oder einen Temperaturgang der Vorwärtsspannung bzw. Kenngrößen davon umfassen. Das erfindungsgemäße Verfahren ist für Top Mount Leuchtdioden einsetzbar und ermöglicht es insbesondere, die gesamte Lichtquellenanordnung in einem ununterbrochenen Produktionsablauf herzustellen. Erst nach der vollständigen Herstellung der Lichtquellenanordnung wird diese zum Erfassen oder zum Ermitteln der optischen und/oder elektrischen Eigenschaften der Leuchtdiode beispielsweise in einer Abgleichvorrichtung in Betrieb genommen. Nachdem die Eigenschaften der Leuchtdiode mittels der Abgleichvorrichtung erfasst oder ermittelt worden sind, wird in Abhängigkeit von diesen Eigenschaften ein einzustellender Widerstandswert des Widerstandselements ermittelt und das bereits an dem Schaltungsträger der Lichtquellenanordnung angeordnete Widerstandselement so abgeglichen, dass sein Widerstandswert dem ermittelten Widerstandswert entspricht.

Das erfindungsgemäße Verfahren ist deutlich zeitsparender und kostengünstiger als bekannte Verfahren, weil der Ablauf zum Herstellen der Lichtquellenanordnung nicht zum Erfassen der Eigenschaften der Leuchtdiode unterbrochen werden muss. Da das Widerstandselement direkt auf dem Schaltungsträger angeordnet wird, muss kein getrennter Schaltungsträger für das Widerstandselement vorgesehen werden. Durch das vorab Anordnen des Widerstandselements auf dem Schaltungsträger braucht bei der Herstellung einer Serie von Lichtquellenanordnungen nur eine Art von Widerstandselementen zum Anordnen auf dem Schaltungsträger vorgehalten zu werden. Dieses Widerstandselement wird dann durch das Abgleichen seines Widerstandswerts an die Eigenschaften der Leuchtdiode individuell angepasst. Insgesamt ergibt sich somit ein Herstellungsverfahren, das nicht nur kostengünstig ist, sondern auch zu relativ wenig Ausschuss führt, weil das Anordnen von falschen Widerstandselementen an einem Schaltungsträger vermieden wird.

In einer vereinfachten Ausgestaltung, nicht Teil der Erfindung, ist es auch möglich, dass das Anordnen des Widerstandselements auf dem Schaltungsträger Teil des Abgleichs des Widerstandswerts ist, wobei zum Abgleich des Widerstandswerts ein Widerstandselement mit einem den erfassten Eigenschaften der Leuchtdiode entsprechenden Widerstandswert ausgewählt und anschließend auf dem Schaltungsträger angeordnet wird.

Es ist bevorzugt, dass die optischen und/oder elektrischen Eigenschaften der Leuchtdiode nach dem Anordnen der Leuchtdiode auf dem Kühlkörper und nach dem Anordnen des Widerstandselements auf dem Schaltungsträger erfasst werden. Hierbei können das Erfassen der Eigenschaften der Leuchtdiode und das Abgleichen des Widerstandselements zu einem einzigen Herstellungsschritt zusammengefasst werden. Das Verfahren wird dadurch vereinfacht, weil die erfassten Eigenschaften der Leuchtdiode nicht längere Zeit zwischengespeichert werden müssen. Zudem wird vermieden, dass es zu Verwechslungen von Leuchtdioden kommt und irrtümlicherweise einer bestimmten Leuchtdiode ein falscher Widerstandswert zugeordnet wird.

Zur Befestigung der mindestens einen Top Mount Leuchtdiode wird diese vorzugsweise auf den Kühlkörper geklebt oder geschraubt. Die elektrische Verbindung zwischen dem Schaltungsträger und der mindestens einen Top Mount Leuchtdiode wird bevorzugt durch Schweißen, Löten oder durch ein Federelement hergestellt. Das Schweißen kann bspw. Teil eines Drahtbonding-Prozesses sein, wobei Bonding-Drähte mit entsprechenden Bonding-Pads auf der Oberseite der Top Mount Leuchtdiode und dem Schaltungsträger stoffschlüssig verbunden werden. Beim Löten kann ein Kontaktierungselement, bspw. in Form eines Metallplättchens oder Metallbändchens, mit den Bonding-Pads der Leuchtdiode und des Schaltungsträgers durch Selektiv-, Wellen-, Laser- oder Induktionslöten stoffschlüssig verbunden werden.

Weiter ist bevorzugt, dass das Widerstandselement einen trimmbaren, vorzugsweise einen lasertrimmbaren Widerstand umfasst, der trimmbare Widerstand direkt auf dem Schaltungsträger angeordnet wird und das Widerstandselement abgeglichen wird, indem der Widerstandswert des trimmbaren Widerstands insbesondere durch Laserabgleichen eingestellt wird. Durch das Laserabgleichen kann der Widerstandswert des Widerstandselements schnell und bei Bedarf auch automatisiert eingestellt werden. Andere Verfahren zum Abgleichen des Widerstandswerts des Widerstandselements sind ebenfalls denkbar.

Alternativ oder ergänzend hierzu kann vorgesehen sein, dass das Widerstandselement ein Widerstandsnetzwerk mit mehreren Festwiderständen aufweist, die Festwiderstände direkt auf dem Schaltungsträger angeordnet werden und das Widerstandselement abgeglichen wird, indem mindestens eine Verbindungsstelle des Widerstandsnetzwerks überbrückt wird und/oder indem in dem Widerstandsnetzwerk vorhandene Überbrückungen durchtrennt werden. Es kann vorgesehen sein, dass die Verbindungsstelle zwei Verbindungspunkte umfasst und dass die Verbindungsstelle überbrückt wird, indem ihre beiden Verbindungspunkte miteinander elektrisch verbunden werden. Das Widerstandsnetzwerk kann als Widerstandskaskade ausgebildet sein, die eine Serienschaltung der Festwiderstände umfasst. Es ist denkbar, jeweils eine durchtrennbare Überbrückung parallel zu mindestens einem Festwiderstand anzuordnen, wobei bevorzugt ist, dass jedem Festwiderstand eine durchtrennbare Überbrückung zugeordnet ist, welche dem entsprechenden Festwiderstand parallelgeschaltet ist.

In einer bevorzugten Ausführungsform der vorliegenden Erfindung ist vorgesehen, dass der Schaltungsträger eine Leiterplatte ist und das Widerstandselement auf der Leiterplatte durch Löten, insbesondere im Rahmen eines SMD-Lötprozesses, angeordnet wird. Die Verwendung der Leiterplatte als Schaltungsträger und die Lötverbindungen zum Verbinden der einzelnen Bauteile mit dem Schaltungsträger haben sich bei der vorgesehenen Anwendung im Bereich der Kraftfahrzeugbeleuchtung als zuverlässig erwiesen und sind dennoch relativ kostengünstig realisierbar.

Als Eigenschaften der Leuchtdiode können beliebige optische und/oder elektrische Eigenschaften der Leuchtdiode erfasst werden, insbesondere solche, die Schwankungen im Fertigungsprozess der Leuchtdioden unterliegen und die bei der Ansteuerung einer bestimmten Leuchtdiode deshalb gesondert berücksichtigt werden müssen. Es ist somit bevorzugt, dass als Eigenschaften der Leuchtdiode optische und/oder elektrische Eigenschaften, vorzugsweise ein mittels der Leuchtdiode bei einer vorgegebenen elektrischen Ansteuerung der Leuchtdiode erzeugbarer Lichtstrom erfasst wird.

Hierbei ist besonders bevorzugt, dass beim Erfassen des Lichtstroms der Top Mount Leuchtdiode der Lichtstrom einer Lichtstromklasse (einem sog. Bin) zugeordnet wird und das Widerstandselement in Abhängigkeit von der Lichtstromklasse abgeglichen wird. Eine Lichtstromklasse entspricht einem bestimmten Wertebereich des von der Leuchtdiode erzeugten Lichtstroms. Beim anschließenden bestimmungsgemäßen Betrieb der Lichtquellenanordnung kann das Steuergerät den Widerstandswert des Widerstandselements erfassen und beispielsweise unter Verwendung einer im Steuergerät abgelegten Tabelle anhand des Widerstandswerts die entsprechende Lichtstromklasse ermitteln und die Ansteuerung der Top Mount Leuchtdiode an die ermittelte Lichtstromklasse anpassen.

Als weitere Lösung der Aufgabe wird eine Lichtquellenanordnung für eine Kraftfahrzeugbeleuchtungseinrichtung gemäß Anspruch 11 vorgeschlagen. Für die Lichtquellenanordnung ergeben sich die oben genannten Vorteile des erfindungsgemäßen Verfahrens.

Hierbei ist besonders bevorzugt, dass die Top Mount Leuchtdiode auf einem Kühlkörper und das Widerstandselement auf einem gemeinsamen Schaltungsträger, vorzugsweise einer Leiterplatte, angeordnet sind.

Alternativ oder ergänzend hierzu kann vorgesehen werden, dass das Widerstandselement eine direkt auf dem Schaltungsträger angeordneten trimmbaren, insbesondere lasertrimmbaren Widerstand und/oder mehrere direkt auf dem Schaltungsträger angeordnete Festwiderstände umfasst. Die Festwiderstände können ein Widerstandsnetzwerk des Widerstandselements bilden, wobei die Festwiderstände vorzugsweise in Serie geschaltet sind.

Weitere Merkmale und Vorteile der Erfindung ergeben sich aus der nachfolgenden Beschreibung, in welcher exemplarische Ausführungsformen der Erfindung anhand der Zeichnungen näher erläutert werden. Dabei zeigen:
- Figur 1: eine Kraftfahrzeugbeleuchtungseinrichtung mit einer erfindungsgemäßen Lichtquellenanordnung gemäß einer bevorzugten Ausführungsform in einer perspektivischen Ansicht;
- Figur 2: die Kraftfahrzeugbeleuchtungseinrichtung aus Fig. 1 in schematischer Ansicht;
- Figur 3: ein Widerstandselement einer erfindungsgemäßen Lichtquellenanordnung gemäß einer zweiten bevorzugten Ausführungsform;
- Figur 4: ein Widerstandselement einer erfindungsgemäßen Lichtquellenanordnung gemäß einer dritten bevorzugten Ausführungsform;
- Figur 5: ein Flussdiagramm eines erfindungsgemäßen Verfahrens zum Herstellen der Lichtquellenanordnung;
- Figur 6: eine erfindungsgemäße Lichtquellenanordnung gemäß einer vierten bevorzugten Ausführungsform;
- Figur 7: eine erfindungsgemäße Lichtquellenanordnung gemäß einer fünften bevorzugten Ausführungsform;
- Figur 8: eine Top Mount Leuchtdiode zur Verwendung in einer erfindungsgemäßen Lichtquellenanordnung in einer perspektivischen Ansicht; und
- Figur 9: die Top Mount Leuchtdiode aus Fig. 8 in einer Seitenansicht.

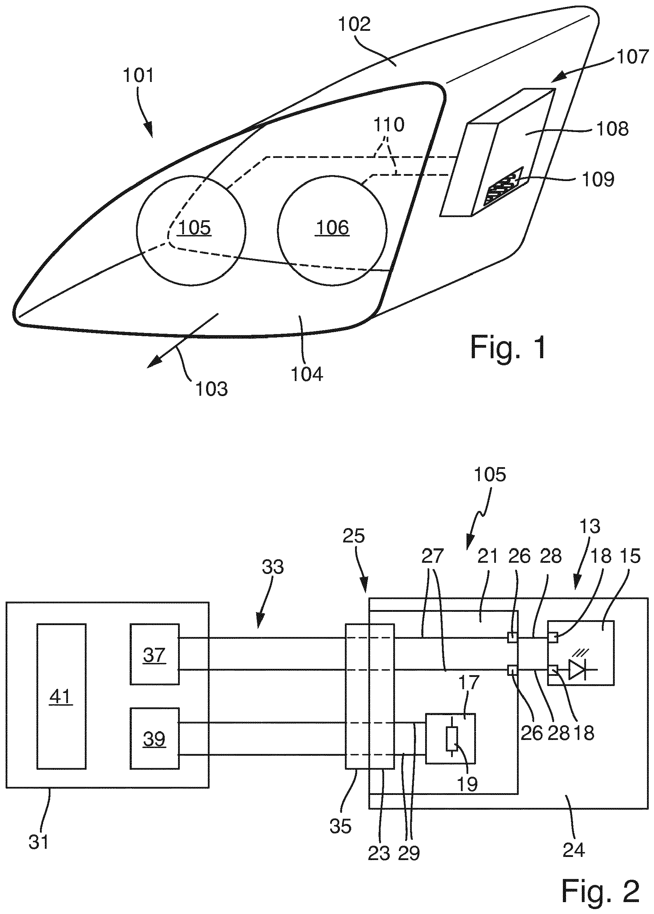

In Figur 1 ist eine Kraftfahrzeugbeleuchtungseinrichtung in Form eines Scheinwerfers in ihrer Gesamtheit mit dem Bezugszeichen 101 bezeichnet. Selbstverständlich könnte die Beleuchtungseinrichtung auch als eine Rückleuchte oder eine Seitenleuchte oder eine sonstige Kraftfahrzeugleuchte für außen oder für den Innenraum ausgebildet sein. Der Scheinwerfer 101 umfasst ein Gehäuse 102, das vorzugsweise aus Kunststoff gefertigt ist. In einer Lichtaustrittsrichtung 103 weist das Scheinwerfergehäuse 102 eine Lichtaustrittsöffnung auf, die durch eine transparente Abdeckscheibe 104 verschlossen ist. Die Abdeckscheibe 104 ist aus transparentem Kunststoff oder Glas gefertigt. Die Scheibe 104 kann ohne optisch wirksame Profile als sogenannte klare Scheibe ausgebildet sein. Alternativ kann die Scheibe 104 zumindest bereichsweise mit optisch wirksamen Profilen (z.B. Zylinderlinsen oder Prismen) versehen sein, die eine Streuung des hindurchtretenden Lichts, vorzugsweise in horizontaler Richtung, bewirken. Der Scheinwerfer 101 ist zum Einbau an einer Anbauseite eines Kraftfahrzeugs vorgesehen. Zwei der gezeigten Scheinwerfer 101 können in einem Fahrzeug eingebaut sein, wobei die an unterschiedlichen Anbauseiten eingebauten Scheinwerfer 101 bezüglich ihres allgemeinen geometrischen äußeren Erscheinungsbildes vorzugsweise spiegelsymmetrisch zueinander ausgebildet sind.

Im Inneren des Scheinwerfergehäuses 102 sind in dem dargestellten Beispiel zwei Lichtmodule 105, 106 angeordnet. Die Lichtmodule 105, 106 sind fest oder relativ zu dem Gehäuse 102 bewegbar angeordnet. Durch eine Relativbewegung der Lichtmodule 105, 106 zum Gehäuse 102 in horizontaler Richtung kann eine dynamische Kurvenlichtfunktion realisiert werden. Bei einer Bewegung der Lichtmodule 105, 106 um eine horizontale Achse, also in vertikaler Richtung, kann eine Leuchtweitenregelung realisiert werden. Selbstverständlich können in dem Scheinwerfergehäuse 102 auch mehr oder weniger als die dargestellten zwei Lichtmodule 105, 106 vorgesehen sein. Eines oder mehrere der Lichtmodule 105, 106 des Scheinwerfers 101 kann eine erfindungsgemäße Lichtquellenanordnung 13 aufweisen, die nachfolgend noch im Detail erläutert wird. Die Lichtmodule 105, 106 können jeweils oder gemeinsam zur Erzeugung unterschiedlicher Lichtverteilungen ausgebildet sein, bspw. eines Abblendlichts, eines Fernlichts und eines Teilfernlichts oder von Teilen davon (z.B. eines Abblendlichtgrundlichts, eines Abblendlichtspots, eines Fernlichtgrundlichts, eines Fernlichtspots etc.). Es ist denkbar, dass sich die Lichtverteilungen der Lichtmodule 105; 106 von an verschiedenen Anbauseiten des Kraftfahrzeugs angeordneten Scheinwerfern 101 zu der resultierenden Lichtverteilung ergänzen.

An der Außenseite des Scheinwerfergehäuses 102 ist ein Steuergerät 107 in einem Steuergerätegehäuse 108 angeordnet. Selbstverständlich kann das Steuergerät 107 auch an einer beliebig anderen Stelle des Scheinwerfers 101 angeordnet sein. Insbesondere kann für jedes der Lichtmodule 105, 106 ein eigenes Steuergerät vorgesehen sein, wobei die Steuergeräte integraler Bestandteil der Lichtmodule 105, 106 sein können. Selbstverständlich kann das Steuergerät 107 auch entfernt von dem Scheinwerfer 101, bspw. im Motorraum des Kraftfahrzeugs, angeordnet sein. Das Steuergerät 107 dient zur Steuerung und/oder Regelung der Lichtmodule 105, 106 bzw. von Teilkomponenten der Lichtmodule 105, 106, wie beispielsweise der Lichtquellenanordnungen 13 der Lichtmodule 105, 106. Die Ansteuerung der Lichtmodule 105, 106 bzw. der Teilkomponenten durch das Steuergerät 107 erfolgt über Verbindungsleitungen 110, die in Figur 1 durch eine gestrichelte Linie lediglich symbolisch dargestellt sind. Über die Leitungen 110 kann auch eine Versorgung der Lichtmodule 105, 106 bzw. der Lichtquellenanordnungen 13 mit elektrischer Energie erfolgen. Die Leitungen 110 sind aus dem Inneren des Scheinwerfers 101 durch eine Öffnung im Scheinwerfergehäuse 102 in das Steuergerätegehäuse 108 geführt und dort an die Schaltung des Steuergerätes 107 angeschlossen. Falls Steuergeräte als integraler Bestandteil der Lichtmodule 105, 106 vorgesehen sind, können die Leitungen 110 und kann die Öffnung in dem Scheinwerfergehäuse 102 entfallen. Das Steuergerät 107 umfasst ein Steckerelement 109 zum Anschluss eines Verbindungskabels zu einer übergeordneten Steuereinheit (z.B. in Form einer sog. Body Controller Unit) und/oder einer Energiequelle (z.B. in Form der Fahrzeugbatterie).

Nachfolgend wird unter Bezugnahme auf die Figuren 2 bis 4 und 6 und 7 die erfindungsgemäße Lichtquellenanordnung 13 näher erläutert. Dabei wird davon ausgegangen, dass das Lichtmodul 105 die erfindungsgemäße Lichtquellenanordnung 13 aufweist und dass das Lichtmodul 105 zur Erzeugung einer Tagfahrlichtverteilung ausgebildet ist. Die Lichtquellenanordnung 13 umfasst eine als Top Mount (oder Top Contact) Leuchtdiode 15 ausgebildete Lichtquelle zum Erzeugen von Licht.

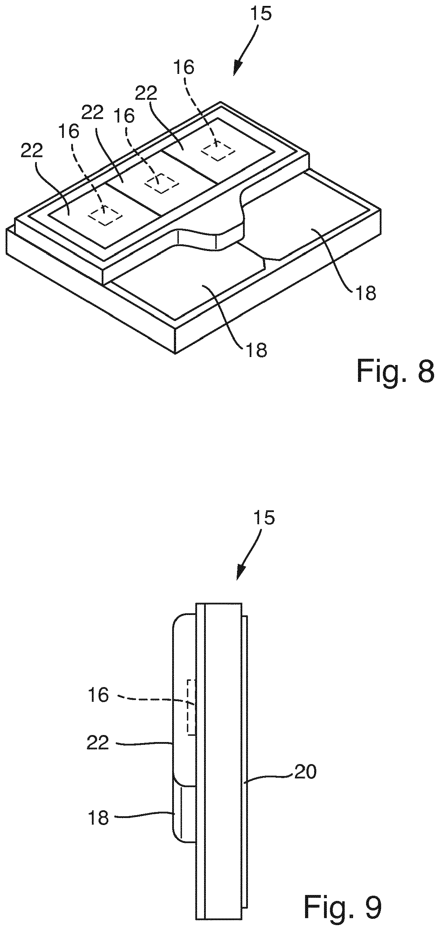

Bei einer Top Mount Leuchtdiode 15 (vgl. Figuren 8 und 9) handelt es sich um ein sog. Submount, das nicht über SMD-Techniken angebunden werden kann. Das Submount umfasst einen oder mehrere LED-Chips 16 zum Emittieren von Licht einer ersten Wellenlänge und elektrische Anschlüsse 18, bspw. in Form von Bonding-Pads, an einer Oberseite des Submounts, sowie ein vollflächiges Wärmespreizelement 20 an der Unterseite des Submounts. Wahlweise kann das Submount auch einen Konverter 22, der bspw. Phosphor umfasst, zum Konvertieren zumindest eines Teils des von den LED-Chips 16 emittierten Lichts (z.B. blaues Licht) in Licht einer anderen Wellenlänge (z.B. gelbes Licht) aufweisen, sodass eine additive Farbmischung des Lichts der ersten und der anderen Wellenlänge Licht einer anderen Farbe (z.B. weißes Licht) ergibt. Das Submount kann wahlweise auch eine Kapselung aus einem Harz- oder Kunststoffmaterial, vorzugsweise aus einem transparenten Material, zum Schutz der elektrischen Bauteile des Submounts aufweisen. Top Mount Leuchtdioden werden mit ihrem Wärmespreizelement 20 unmittelbar auf einem Kühlkörper 24 (vgl. Figur 2) befestigt. Dadurch ergibt sich ein besonders guter Wärmeübergang zwischen den LED-Chips 16 und dem Kühlkörper 24 bzw. der Umgebung.

Obwohl in dem Lichtmodul 105 mehrere Lichtquellenanordnungen 13 vorgesehen werden können, ist in der Figur 2 lediglich eine Lichtquellenanordnung 13 eingezeichnet. Außerdem kann die Lichtquellenanordnung 13 auch mehrere Leuchtdioden 15 umfassen, die beispielsweise in Serie geschaltet sein können. Die Lichtquellenanordnung 13 weist außerdem ein Widerstandselement 17 auf, das einen trimmbaren, insbesondere einen lasertrimmbaren Widerstand 19 umfasst.

Die Top Mount Leuchtdiode 15 ist direkt auf dem Kühlkörper 24 befestigt. Dies kann bspw. mittels Kleben oder Schrauben erfolgen. Das Widerstandselement 17 ist auf einem als Leiterplatte ausgebildeten Schaltungsträger 21 der Lichtquellenanordnung 13 angeordnet. Auf dem Schaltungsträger 21 ist außerdem ein erstes Steckelement 23 eines Steckverbinders 25 des Lichtmoduls 105 angeordnet. Erste Verbindungen 27, die auf dem Schaltungsträger 21 angeordnet sind und in der gezeigten Ausführungsform bspw. als Leiterbahnen ausgebildet sind, stellen eine elektrische Verbindung zwischen elektrischen Anschlüssen 26, bspw. in der Form von Bonding-Pads, des Schaltungsträgers 21 und dem ersten Steckelement 23 her. Die elektrische Verbindung zwischen dem Schaltungsträger 21 bzw. dessen Anschlüssen 26 und der Top Mount Leuchtdiode 15 bzw. deren Anschlüsse 18 wird bevorzugt durch Schweißen, Löten oder durch ein Federelement hergestellt. Das Schweißen kann bspw. Teil eines Drahtbonding-Prozesses sein, wobei - wie in Figur 2 gezeigt - Bonding-Drähte 28 mit den Bonding-Pads 18, 26 auf der Oberseite der Top Mount Leuchtdiode 15 und dem Schaltungsträger 21 stoffschlüssig verbunden werden. Beim Löten kann ein Kontaktierungselement, bspw. in Form eines Metallplättchens oder Metallbändchens, mit den Bonding-Pads 18, 26 der Leuchtdiode 15 und des Schaltungsträgers 21 durch Selektiv-, Wellen-, Laser- oder Induktionslöten stoffschlüssig verbunden werden.

In entsprechender Weise weist der Schaltungsträger 21 zweite Verbindungen 29 auf, welche auf dem Schaltungsträger 21 angeordnet sind und bspw. als Leiterbahnen realisiert sind. Die zweite Verbindungen 29 stellen eine elektrische Verbindung zwischen dem Widerstandselement 17 und dem ersten Steckelement 23 her.

Ein Steuergerät 31, das bspw. das Steuergerät 107 der Beleuchtungseinrichtung 101 ist, dient zum Steuern und/oder Regeln der Lichtquellenanordnung 13 bzw. der Top Mount Leuchtdiode 15. Das Steuergerät 31 ist mittels Verbindungsleitungen 33, an deren von dem Steuergerät 31 abgewandten Enden ein zweites Steckelement 35 des Steckverbinders 25 angeordnet ist, verbunden. Der Steckverbinder 25 bildet somit eine lösbare elektrische Verbindung zwischen dem Steuergerät 31 und der Lichtquellenanordnung 13.

Über die zwei Verbindungsleitungen 33 ist bei zusammengesteckten Steckelementen 23, 35 des Steckverbinders 25 eine Ansteuerschaltung 37 des Steuergeräts 31 mit den ersten Verbindungen 27 des Schaltungsträgers 21 und somit mit der Top Contact Leuchtdiode 15 verbunden. Weiterhin ist eine Messeinrichtung 39 zum Erfassen eines Widerstandswerts R des Widerstandselements 17 über zwei weitere Verbindungsleitungen 33, den Steckverbinder 25 und die zweiten Verbindungen 29 des Schaltungsträgers 21 bei zusammengesteckten Steckelementen 23, 35 mit dem Widerstandselement 17 elektrisch verbunden.

In der gezeigten Ausführungsform sind die ersten Verbindungen 27 und die zweiten Verbindungen 29 vollständig voneinander getrennt. Jede der beiden Verbindungen 27, 29 umfasst zwei elektrische Leiter. Folglich sind vier Verbindungsleitungen 33 zwischen dem Steuergerät 31 und der Lichtquellenanordnung 13 vorhanden. Abweichend hiervon kann auch ein gemeinsamer Leiter für die beiden Verbindungen 27, 29 vorgesehen sein, sodass lediglich drei Verbindungsleitungen 33 erforderlich sind. In beiden Ausführungsformen sind die ersten Verbindungen 27 und die zweiten Verbindungen 29 jedoch so weit voneinander getrennt, dass das Steuergerät 31 den Widerstandswert R unabhängig vom Betriebszustand der Top Mount Leuchtdiode 15, das heißt ohne diesen Betriebszustand berücksichtigen zu müssen, erfassen kann.

Ferner weist das Steuergerät 31 einen bspw. als Mikrocontroller 41 ausgeführten programmierbaren Digitalrechner auf, der zum Ausführen eines hier nicht im Detail beschriebenen Verfahrens zum Betreiben des Lichtmoduls 105 eingerichtet beziehungsweise programmiert ist. Damit der Mikrocontroller 41 die Top Mount Leuchtdiode 15 ansteuern kann, ist er mit der Ansteuerschaltung 37 des Steuergeräts 31 verbunden. Außerdem ist der Mikrocontroller 41 mit der Messeinrichtung 39 des Steuergeräts 31 verbunden, so dass der Mikrocontroller 41 mittels der Messeinrichtung 39 den Widerstandswert R des Widerstandselements 17 erfassen kann.

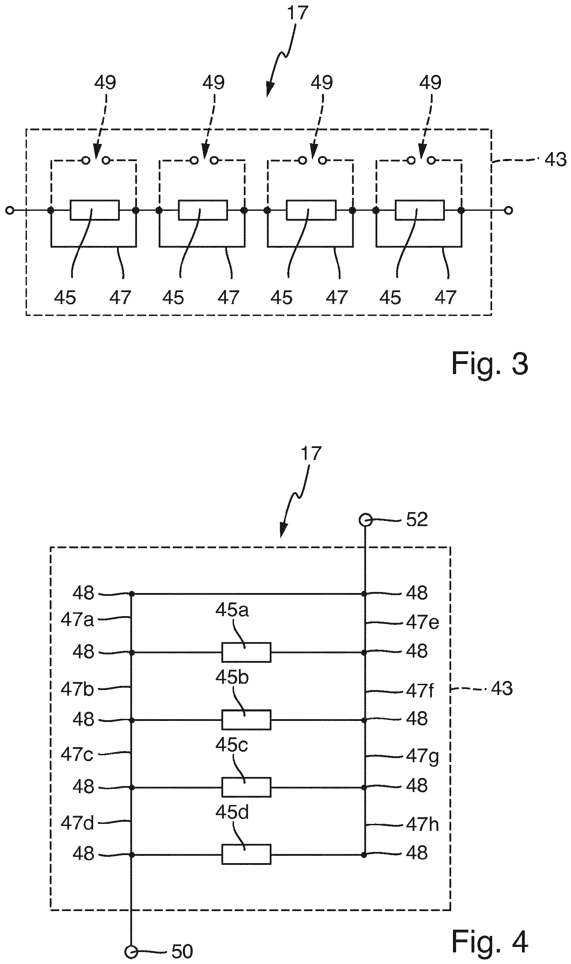

Anstelle des trimmbaren Widerstands 19 kann das Widerstandselement 17 auch - wie in Figur 3 dargestellt - ein Widerstandsnetzwerk 43 aufweisen. Das Widerstandsnetzwerk 43 ist als Widerstandskaskade ausgebildet und umfasst mehrere in Serie geschaltete Festwiderstände 45. Jedem Festwiderstand 45 ist eine durchtrennbare Überbrückung 47 parallel geschaltet. Die Überbrückungen 47 können als Leiterbahnen auf dem Schaltungsträger 21 ausgeführt werden. Anstelle der Überbrückungen 47 können auch Verbindungsstellen 49, die in Figur 3 gestrichelt eingezeichnet sind, vorgesehen werden. Mittels der Verbindungsstellen 49 kann ein Festwiderstand 45 überbrückt werden, indem zwei Verbindungspunkte (ohne Bezugszeichen) der entsprechenden Verbindungsstelle 49 miteinander elektrisch verbunden werden.

Das Widerstandsnetzwerk 43 kann auch - wie in Figur 4 dargestellt - auch als eine Parallelschaltung mehrerer Festwiderstände 45 ausgebildet sein. Dieses Widerstandsnetzwerk 43 weist eine erste Serienschaltung von ersten durchtrennbaren Überbrückungen 47a, 47b, 47c, 47d und eine zweite Serienschaltung von zweiten durchtrennbaren Überbrückungen 47e, 47f, 47g, 47h auf. Ein erstes Ende der ersten Serienschaltung bildet einen ersten Anschluss 50 des Widerstandsnetzwerks 43 bzw. des Widerstandselements 17. Ein erstes Ende der zweiten Serienschaltung bildet einen zweiten Anschluss 52 des Widerstandsnetzwerks 43 bzw. des Widerstandselements 17. Die Anzahl der ersten Überbrückungen 47a, 47b, 47c, 47d und die Anzahl der zweiten Überbrückungen 47e, 47f, 47g, 47h entspricht jeweils der Anzahl der Festwiderstände 45.

An Enden der Überbrückungen 47a -h befinden sich Punkte 48, die sich auf bestimmte Orte innerhalb der Schaltungstopologie des Widerstandsnetzwerks 43 beziehen, wobei der dem jeweiligen Anschluss 50, 52 am nächsten liegende Punkt 48 als erster Punkt 48 und der am weitesten von dem jeweiligen Anschluss entfernte Punkt 48 als letzter Punkt 48 der ersten bzw. der zweiten Serienschaltung bezeichnet wird.

Der erste Punkt 48 der ersten Serienschaltung ist über einen Festwiderstand 45d mit dem letzten Punkt 48 der zweiten Serienschaltung verbunden. Der auf einen bestimmten betrachteten Punkt 48 der ersten Serienschaltung folgende Punkt 48 ist über einen Festwiderstand mit demjenigen Punkt 48 der zweiten Serienschaltung verbunden, der dem Punkt 48 der zweiten Serienschaltung vorangeht, mit dem der betrachtete Punkt 48 verbunden ist. Der vorletzte Punkt 48 der ersten Serienschaltung ist über den Festwiderstand 45a mit dem zweiten Punkt 48 der zweiten Serienschaltung verbunden. Schließlich ist ein zweites Ende der ersten Serienschaltung, das dem letzten Punkt 48 der ersten Serienschaltung entspricht, direkt ohne Festwiderstand mit dem ersten Ende, d. h. dem ersten Punkt 48 der zweiten Serienschaltung verbunden.

Der Widerstandswert R des gesamten Widerstandsnetzwerks 43 kann durch Durchtrennen einer oder mehrerer Überbrückungen 47a-h eingestellt werden. In der Darstellung von Figur 4 ist keine Überbrückung 47a -h durchtrennt, und der Widerstandswert R ist im Wesentlichen Null, weil die ersten Überbrückungen 47a-d die beiden Anschlüsse 50, 52 direkt miteinander verbinden. Werden beispielsweise ausschließlich die Überbrückungen 47d, 47g, 47b und 47e durchtrennt, so ergibt sich eine zwischen den beiden Anschlüssen 50, 52 angeordnete Serienschaltung aller Festwiderstände 45a-d. Werden ausschließlich die Überbrückungen 47c und 47e durchtrennt, so ergibt sich zwischen den beiden Anschlüssen 50, 52 eine Parallelschaltung der Festwiderstände 45a und 45b, die mit einer Parallelschaltung der Festwiderstände 45c und 45d in Serie geschaltet ist. Durch eine geeignete Wahl von Werten der einzelnen Festwiderstände 45a-d kann eine große Zahl unterschiedlich einstellbarer Widerstandswerte R des Widerstandsnetzwerks 43 realisiert werden.

Beide in den Figuren 3 und 4 gezeigten Widerstandnetzwerke 43 weisen vier Festwiderstände 45, 45a-d auf. Es kann jedoch auch eine andere Anzahl von Festwiderständen 45, 45a-d vorgesehen werden. Die Festwiderstände 45, 45a-d können identische Werte oder zumindest teilweise verschiedene Werte aufweisen. Die Überbrückungen 47, 47a-h können beispielsweise als durchtrennbare Leiterbahnabschnitte ausgebildet sein.

Der Widerstandswert R des Widerstandselements 17 ist in Abhängigkeit von optischen und/oder elektrischen Eigenschaften der Leuchtdiode 15 gewählt. Beispielsweise kann der Widerstandswert R derart gewählt werden, dass er eine bestimmte Lichtstromklasse (sog. Bin), zu der die Top Mount Leuchtdiode 15 der Lichtquellenanordnung 13 gehört, charakterisiert. Beim Betreiben des Lichtmoduls 105 erfasst das Steuergerät 31 mittels der Messeinrichtung 39 den Widerstandswert R. Anschließend ermittelt der Mikrocontroller 41 in Abhängigkeit von dem erfassten Widerstandswert R die Lichtstromklasse der Leuchtdiode 15 und steuert mittels der Ansteuerschaltung 37 die Leuchtdiode 15 so an, dass sie einen vorgegebenen Lichtstrom erzeugt. Hierdurch wird erreicht, dass der von der Leuchtdiode 15 erzeugte Lichtstrom zumindest im Wesentlichen von den optischen und/oder elektrischen Eigenschaften der Top Mount Leuchtdiode 15, insbesondere deren Zugehörigkeit zu einer bestimmten Lichtstromklasse, unabhängig ist. Die Fertigungstoleranzen der Leuchtdiode 15, was die optischen und/oder elektrischen Eigenschaften angeht, werden dadurch zumindest weitgehend ausgeglichen.

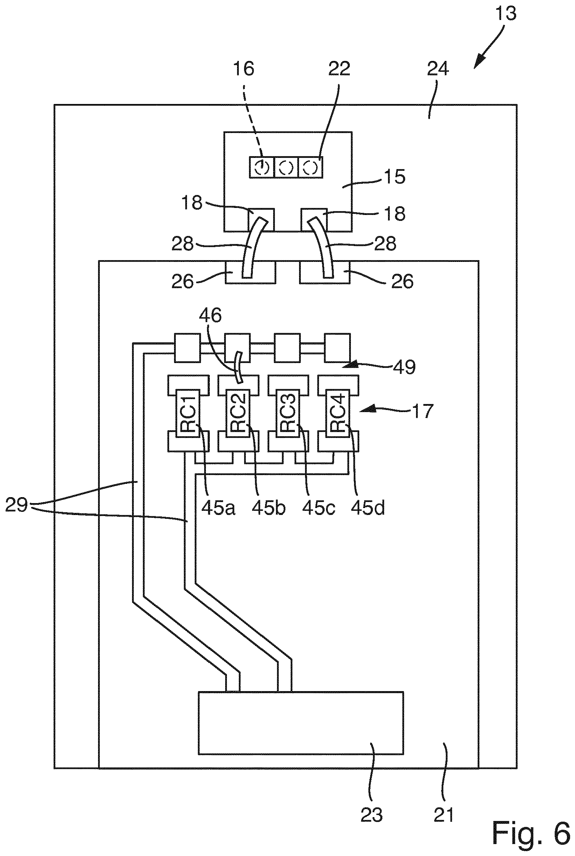

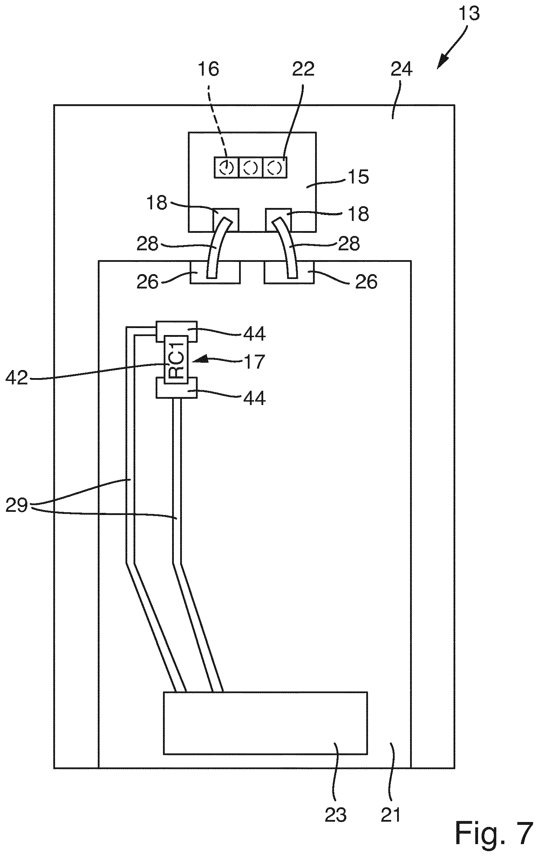

Die Figuren 6 und 7 zeigen weitere Ausführungsbeispiele einer erfindungsgemäßen Lichtquellenanordnung 13. In Figur 6 umfasst das Widerstandselement 17 ebenfalls ein Widerstandsnetzwerk 43 mit mehreren Festwiderständen 45 und Verbindungsstellen 49, die überbrückt werden können, um einzelne Festwiderstände 45 gezielt zuschalten zu können. Dazu können zwei Verbindungspunkte (ohne Bezugszeichen), die bspw. als Bonding-Pads ausgebildet sind, der entsprechenden Verbindungsstelle 49 miteinander elektrisch verbunden werden. In dem Beispiel ist der Widerstand 45b mittels eines Bonding-Drahts 46 zugeschaltet. In Figur 7 umfasst das Widerstandselement 17 einen nicht-trimmbaren Festwiderstand 42, der auf den Schaltungsträger 21 aufgeklebt und dadurch automatisch an den als Bonding-Pads ausgebildeten Kontaktstellen 44 des Schaltungsträgers 21 kontaktiert ist. Dabei ist das Anordnen des Widerstandselements 17 auf dem Schaltungsträger 21 Teil des Abgleichs des Widerstandswerts R, wobei zum Abgleich des Widerstandswerts ein Widerstandselement 17 mit einem den erfassten Eigenschaften der Top Mount Leuchtdiode 15 entsprechenden Widerstandswert R ausgewählt und auf dem Schaltungsträger 21 angeordnet wird.

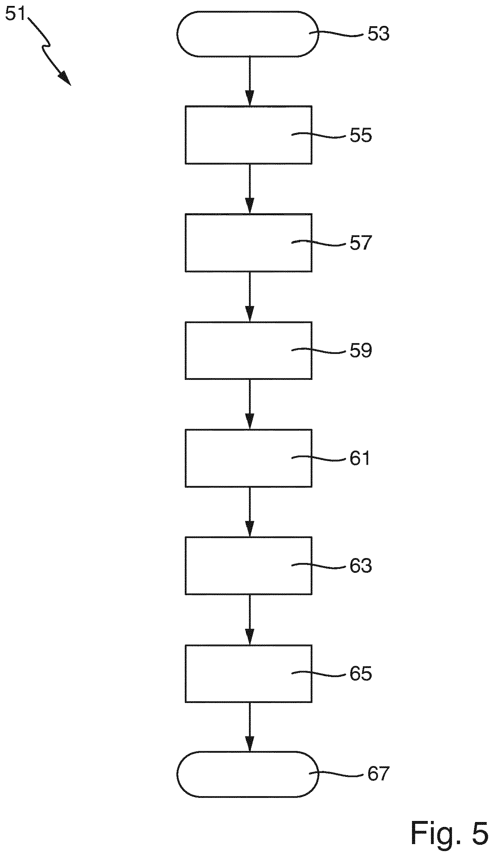

Im Folgenden wird anhand der Figur 5 ein Verfahren 51 zum Herstellen der Lichtquellenanordnung 13 näher beschrieben. Nach einem Start 53 des Verfahrens wird in einem Schritt 55 der Kühlkörper 24 bereitgestellt. Anschließend wird in einem Schritt 57 die mindestens eine Top Mount Leuchtdiode 15 bereitgestellt und auf dem Kühlkörper 24 befestigt. In einem Schritt 59 wird dann der Schaltungsträger 21 bereitgestellt und das Widerstandselement 17 darauf angeordnet, d.h. befestigt und elektrisch kontaktiert. Das Bereitstellen des Schaltungsträgers 21 kann bspw. dadurch geschehen, dass eine entsprechende Leiterplatte hergestellt wird. Das elektrische Kontaktieren des trimmbaren Widerstands 19 bzw. der Festwiderstände 45, 45a-d des Widerstandsnetzwerks 43 kann mittels eines SMD-Lötprozesses erfolgen. Der trimmbare Widerstand 19 wird direkt auf dem Schaltungsträger 21 angeordnet. Alternativ werden bei einem Widerstandsnetzwerk 43 die einzelnen Festwiderstände 45, 45a-d sowie die Überbrückungen 47 beziehungsweise die Verbindungsstelle 49 direkt auf dem Schaltungsträger 21 angeordnet.

In einem folgenden Schritt 61 wird eine elektrische Verbindung zwischen dem Schaltungsträger 21 und der mindestens einen Top Mount Leuchtdiode 15 hergestellt. In einem Schritt 63 werden optische und/oder elektrische Eigenschaften der Top Mount Leuchtdiode 15 erfasst. Hierzu kann eine Abgleichvorrichtung verwendet werden, die die Leuchtdiode 15 auf eine vorbestimmte Weise, beispielsweise mit einem bestimmten Strom, ansteuert bzw. betreibt und optische Eigenschaften, insbesondere den von der Top Mount Leuchtdiode 15 erzeugten Lichtstrom, misst. Üblicherweise wird die Leuchtdiode 15 nicht im Montageprozess, sondern vom LED-Hersteller bereits im Rahmen ihrer Herstellung vermessen und in entsprechende Bin-Klassen einsortiert. Das Erfassen der optischen und/oder elektrischen Eigenschaften der Top Mount Leuchtdiode 15 im Schritt 63 kann somit auch einfach das Einlesen von zuvor ermittelten und der entsprechenden Bin-Klasse der Leuchtdiode 15 zugeordneten optischen und/oder elektrischen Eigenschaften der Top Mount Leuchtdiode 15 umfassen.

Anhand von den Ergebnissen der im Schritt 63 durchgeführten Messungen bzw. anhand der zuvor vom LED-Hersteller ermittelten optischen und/oder elektrischen Eigenschaften der Bin-Klasse der zugeführten Top Mount Leuchtdioden 15, insbesondere von dem gemessenen Lichtstrom, ermittelt die Abgleichvorrichtung einen Sollwert für den Widerstandswert R des Widerstandselements 17. Hierbei kann der Leuchtdiode 15 zunächst einer Lichtstromklasse zugeordnet werden und der Sollwert in Abhängigkeit von der zugeordneten Lichtstromklasse ermittelt werden.

Danach gleicht die Abgleichvorrichtung in einem Schritt 65 den Widerstandswert R des Widerstandselements 17 in Abhängigkeit von den erfassten Eigenschaften der Top Mount Leuchtdiode 15 durch Abgleichen des trimmbaren Widerstands 19, insbesondere durch Laserabgleichen des lasertrimmbaren Widerstands 19, durch Auftrennen der Überbrückungen 47 und/oder durch Verbinden der Verbindungspunkte der Verbindungsstellen 49 derart ab, dass der Widerstandswert R dem im Schritt 63 berechneten Sollwert entspricht. Zum Auftrennen der Überbrückungen 47 können geeignete mechanische und/oder chemische Verfahren angewendet und/oder ein Laser eingesetzt werden. In einem Schritt 67 ist das Verfahren beendet.

Bei dem Verfahren 51 wird also vorzugsweise zunächst die Lichtquellenanordnung 13 mit einem standardisierten, nicht abgeglichenen Widerstandselement 17 hergestellt, dessen Widerstandswert R noch nicht die optischen und/oder elektrischen Eigenschaften der Leuchtdiode 15 anzuzeigen vermag. Erst nachdem die Lichtquellenanordnung 13 vollständig zusammengebaut worden ist, wird das Widerstandselement 17 abgeglichen, das heißt sein Widerstandswert R in Abhängigkeit von den Eigenschaften der Top Mount Leuchtdiode 15 eingestellt. Mit dem erfindungsgemäßen Verfahren gelingt es also, das Festlegen des Widerstandselements 17 auf den Schritt 65, das heißt an das an Ende des Verfahrens 51 nach hinten zu verlegen, was die Herstellung der Lichtquellenanordnung 13 vereinfacht und auch die Herstellung von relativ einfach aufgebauten Lichtquellenanordnungen 13 erlaubt.

## Patentansprüche

1. Verfahren (51) zum Herstellen einer Lichtquellenanordnung (13) für eine Kraftfahrzeugbeleuchtungseinrichtung (101) mit mindestens einer Leuchtdiode (15) zum Erzeugen von Licht und einem Widerstandselement (17) zum Vorgeben von optischen und/oder elektrischen Eigenschaften der Leuchtdiode (15) an ein Steuergerät (31; 107) zum Steuern und/oder Regeln der Lichtquellenanordnung (13),
**gekennzeichnet durch** die folgenden Schritte:
- Bereitstellen (55) eines Kühlkörpers (24),
- Bereitstellen (57) mindestens einer Top Mount Leuchtdiode (15) in der Form eines Submounts, das einen oder mehrere LED-Chips (16) zum Emittieren von Licht einer ersten Wellenlänge und an seiner Oberseite elektrische Anschlüsse (18) und an seiner Unterseite ein vollflächiges Wärmespreizelement (20) umfasst,
- Befestigen (57) der mindestens einen Top Mount Leuchtdiode (15) mit ihrem Wärmespreizelement (20) unmittelbar auf dem Kühlkörper (24),
- Bereitstellen (59) eines Schaltungsträgers (21),
- Anordnen (59) des Widerstandselements (17) auf dem Schaltungsträger (21),
- Herstellen (61) einer elektrischen Verbindung (28) zwischen dem Schaltungsträger (21) und der mindestens einen Top Mount Leuchtdiode (15),
- Erfassen (63) der Eigenschaften der Leuchtdiode (15) und
- Abgleich (65) eines Widerstandswerts (R) des Widerstandselements (17) in Abhängigkeit von den erfassten Eigenschaften der Leuchtdiode (15).

2. Verfahren (51) nach Anspruch 1, **dadurch gekennzeichnet, dass**
das Widerstandselement (17) vor dem Abgleich (65) des Widerstandswerts (R) auf dem Schaltungsträger (21) angeordnet wird (59).

3. Verfahren (51) nach Anspruch 1, **dadurch gekennzeichnet, dass**
das Anordnen (59) des Widerstandselements (17) auf dem Schaltungsträger (21) Teil des Abgleichs (65) des Widerstandswerts (R) ist, wobei zum Abgleich (65) des Widerstandswerts (R) ein Widerstandselement (17) mit einem den erfassten Eigenschaften der Leuchtdiode (15) entsprechenden Widerstandswert (R) ausgewählt und auf dem Schaltungsträger (21) angeordnet wird.

4. Verfahren (51) nach einem der vorhergehenden Ansprüche, **dadurch gekennzeichnet, dass**
die mindestens eine Top Mount Leuchtdiode (15) auf den Kühlkörper (24) geklebt oder geschraubt wird.

5. Verfahren (51) nach einem der vorhergehenden Ansprüche, **dadurch gekennzeichnet, dass**
die elektrische Verbindung (28) zwischen dem Schaltungsträger (21) und der mindestens einen Top Mount Leuchtdiode (15) durch Schweißen, Löten oder durch ein Federelement hergestellt wird.

6. Verfahren (51) nach einem der vorhergehenden Ansprüche, **dadurch gekennzeichnet, dass**
das Widerstandselement (17) einen trimmbaren, insbesondere einen lasertrimmbaren, Widerstand (19) umfasst, der trimmbare Widerstand (19) direkt auf dem Schaltungsträger (21) angeordnet wird und der Widerstandswert (R) des Widerstandselements (17) abgeglichen wird, indem der Widerstandswert (R) des trimmbaren Widerstands (19), insbesondere durch Laserabgleichen, eingestellt wird.

7. Verfahren (51) nach einem der vorhergehenden Ansprüche, **dadurch gekennzeichnet, dass**
das Widerstandselement (17) ein Widerstandsnetzwerk (43) mit mehreren Festwiderständen (45; 45a-d) aufweist, die Festwiderstände (45; 45a-d) direkt auf dem Schaltungsträger (21) angeordnet werden und der Widerstandswert (R) des Widerstandselements (17) abgeglichen wird, indem mindestens eine Verbindungsstelle (49) des Widerstandsnetzwerks (43) überbrückt wird und/oder indem in dem Widerstandsnetzwerk (43) vorhandene Überbrückungen (47; 47a-h) durchtrennt werden.

8. Verfahren (51) nach einem der vorhergehenden Ansprüche, **dadurch gekennzeichnet, dass**
der Schaltungsträger (21) eine Leiterplatte ist und das Widerstandselement (17) auf der Leiterplatte durch Löten, insbesondere im Rahmen eines SMD-Lötprozesses, angeordnet wird.

9. Verfahren (51) nach einem der vorhergehenden Ansprüche, **dadurch gekennzeichnet, dass**
als Eigenschaften der Leuchtdiode (15) optische und/oder elektrische Eigenschaften, vorzugsweise ein mittels der Leuchtdiode (15) bei einer vorgegebenen elektrischen Ansteuerung der Leuchtdiode (15) erzeugbarer Lichtstrom erfasst wird.

10. Verfahren (51) nach Anspruch 9, **dadurch gekennzeichnet, dass**
beim Erfassen des Lichtstroms der Leuchtdiode (15) der Lichtstrom einer Lichtstromklasse zugeordnet wird und der Widerstandswert (R) des Widerstandselements (17) in Abhängigkeit von der Lichtstromklasse abgeglichen wird.

11. Lichtquellenanordnung (13) für eine Kraftfahrzeugbeleuchtungseinrichtung (101), mit mindestens einer Leuchtdiode (15) zum Erzeugen von Licht und einem Widerstandselement (17) zum Vorgeben von optischen und/oder elektrischen Eigenschaften der Leuchtdiode (15) an ein Steuergerät (31; 107) zum Steuern und/oder Regeln der Lichtquellenanordnung (13),
**dadurch gekennzeichnet, dass**
die Leuchtdiode (15) als eine Top Mount Leuchtdiode in der Form eines Submounts ausgebildet ist, das einen oder mehrere LED-Chips (16) zum Emittieren von Licht einer ersten Wellenlänge und an seiner Oberseite elektrische Anschlüsse (18) und an seiner Unterseite ein vollflächiges Wärmespreizelement (20) umfasst, wobei die Top Mount Leuchtdiode (15) mit ihrem Wärmespreizelement (20) unmittelbar auf einem Kühlkörper (24) befestigt ist, das Widerstandselement (17) auf einem Schaltungsträger (21) der Lichtquellenanordnung (13) angeordnet ist, eine elektrische Verbindung (28) zwischen dem Schaltungsträger (21) und der Top Mount Leuchtdiode (15) hergestellt ist und ein Widerstandswert (R) des Widerstandselements (17) in Abhängigkeit von zuvor erfassten Eigenschaften der Leuchtdiode (15) abgeglichen ist.

12. Lichtquellenanordnung (13) nach Anspruch 11, **dadurch gekennzeichnet, dass**
das Widerstandelement (17) einen direkt auf dem Schaltungsträger (21) angeordneten trimmbaren, insbesondere lasertrimmbaren Widerstand (19) und/oder mehrere direkt auf dem Schaltungsträger (21) angeordnete Festwiderstände (45; 45a-d) umfasst.

13. Lichtquellenanordnung (13) nach Anspruch 11 oder 12, **dadurch gekennzeichnet, dass**
die elektrischen Anschlüsse (18) als Bonding-Pads ausgebildet sind.

## Claims

1. Method (51) for producing a light source arrangement (13) for a motor vehicle lighting device (101) having at least one light-emitting diode (15) for generating light and a resistor element (17) for pre-setting optical and/or electrical properties of the light-emitting diode (15) to a control unit (31; 107) for controlling and/or regulating the light source arrangement (13),
**characterised by** the following steps:
- providing (55) a heat sink (24),
- providing (57) at least one top mount light emitting diode (15) in the form of a submount comprising one or more LED chips (16) for emitting light of a first wavelength and electrical connections (18) on its upper side and a full area heat spreader element (20) on its lower side,
- fixing (57) the at least one top mount light emitting diode (15) with its heat spreading element (20) directly on the heat sink (24),
- providing (59) a circuit carrier (21),
- arranging (59) the resistor element (17) on the circuit carrier (21),
- establishing (61) an electrical connection (28) between the circuit carrier (21) and the at least one top mount light emitting diode (15),
- detecting (63) the properties of the light-emitting diode (15) and
- adjusting (65) a resistance value (R) of the resistor element (17) as a function of the detected properties of the light-emitting diode (15).

2. Method (51) according to claim 1, **characterized in that**
the resistor element (17) is arranged (59) on the circuit carrier (21) prior to the adjustment (65) of the resistance value (R).

3. Method (51) according to claim 1, **characterized in that**
the arrangement (59) of the resistor element (17) on the circuit carrier (21) is part of the adjustment (65) of the resistance value (R), wherein for the adjustment (65) of the resistance value (R) a resistor element (17) with a resistance value (R) corresponding to the detected properties of the light-emitting diode (15) is selected and arranged on the circuit carrier (21).

4. Method (51) according to one of the preceding claims, **characterized in that**
the at least one top mount light emitting diode (15) is glued or screwed onto the heat sink (24).

5. Method (51) according to any one of the preceding claims, **characterized in that**
the electrical connection (28) between the circuit carrier (21) and the at least one top mount light emitting diode (15) is made by welding, soldering or by a spring element.

6. Method (51) according to any one of the preceding claims, **characterized in that**
the resistor element (17) comprises a trimmable, in particular a laser trimmable, resistor (19), the trimmable resistor (19) is arranged directly on the circuit carrier (21) and the resistance value (R) of the resistor element (17) is adjusted by setting the resistance value (R) of the trimmable resistor (19), in particular by laser trimming.

7. Method (51) according to one of the preceding claims, **characterized in that**
the resistor element (17) comprises a resistor network (43) with a plurality of fixed resistors (45; 45a-d), the fixed resistors (45; 45a-d) are arranged directly on the circuit carrier (21), and the resistance value (R) of the resistor element (17) is adjusted by bridging at least one junction (49) of the resistor network (43) and/or by cutting bridges (47; 47a-h) present in the resistor network (43).

8. Method (51) according to one of the preceding claims, **characterized in that**
the circuit carrier (21) is a printed circuit board and the resistor element (17) is arranged on the printed circuit board by soldering, in particular within the scope of an SMD soldering process.

9. Method (51) according to one of the preceding claims, **characterized in that**
optical and/or electrical properties, preferably a luminous flux that can be generated by means of the light-emitting diode (15) when the light-emitting diode (15) is electrically driven in a predetermined manner, are detected as properties of the light-emitting diode (15).

10. Method (51) according to claim 9, **characterized in that**
when the luminous flux of the light-emitting diode (15) is detected, the luminous flux is assigned to a luminous flux class and the resistance value (R) of the resistor element (17) is adjusted as a function of the luminous flux class.

11. Light source arrangement (13) for a motor vehicle lighting device (101), having at least one light-emitting diode (15) for generating light and a resistor element (17) for pre-setting optical and/or electrical properties of the light-emitting diode (15) to a control unit (31; 107) for controlling and/or regulating the light source arrangement (13),
**characterised in that**
the light-emitting diode (15) is designed as a top-mount light-emitting diode in the form of a submount which comprises one or more LED chips (16) for emitting light of a first wavelength and electrical connections (18) on its top side and a full-area heat-spreading element (20) on its underside, the top-mount light-emitting diode (15) being fastened with its heat-spreading element (20) directly on a heat sink (24), the resistor element (17) is arranged on a circuit carrier (21) of the light source arrangement (13), an electrical connection (28) is produced between the circuit carrier (21) and the top-mount light-emitting diode (15), and a resistance value (R) of the resistor element (17) is adjusted as a function of previously detected properties of the light-emitting diode (15).

12. Light source arrangement (13) according to claim 11, **characterized in that**
the resistor element (17) comprises a trimmable, in particular laser-trimmable resistor (19) arranged directly on the circuit carrier (21) and/or a plurality of fixed resistors (45; 45a-d) arranged directly on the circuit carrier (21).

13. Light source arrangement (13) according to claim 11 or 12, **characterized in that**
the electrical connections (18) are formed as bonding pads.

## Revendications

1. Procédé (51) de fabrication d'un agencement de sources lumineuses (13) pour un dispositif d'éclairage de véhicule automobile (101) comprenant au moins une diode électroluminescente (15) permettant de produire de la lumière et un élément de résistance (17) permettant de prédéfinir les propriétés optiques et/ou électriques de la diode électroluminescente (15) pour un appareil de commande (31; 107) permettant de commander et/ou régler l'agencement de sources lumineuses (13),
**caractérisé par** les étapes ci-dessous consistant à :
- fournir (55) un dissipateur thermique (24),
- fournir (57) au moins une diode électroluminescente à montage en surface (15) sous la forme d'une embase comprenant une ou plusieurs puce(s) LED (16) permettant d'émettre de la lumière d'une première longueur d'onde et comprenant sur sa face supérieure des connexions électriques (18) et sur sa face inférieure un élément d'étalement thermique (20) occupant toute la surface,
- fixer (57) ladite au moins une diode électroluminescente à montage en surface (15) avec son élément d'étalement thermique (20) directement sur le dissipateur thermique (24),
- fournir (59) un support de circuit (21),
- agencer (59) l'élément de résistance (17) sur le support de circuit (21),
- créer (61) une connexion électrique (28) entre le support de circuit (21) et ladite au moins une diode électroluminescente à montage en surface (15),
- saisir (63) les propriétés de la diode électroluminescente (15), et
- ajuster (65) une valeur de résistance (R) de l'élément de résistance (17) en fonction des propriétés saisies de la diode électroluminescente (15).

2. Procédé (51) selon la revendication 1, **caractérisé en ce que**
l'élément de résistance (17) est agencé (59) sur le support de circuit (21) avant l'ajustement (65) de la valeur de résistance (R).

3. Procédé (51) selon la revendication 1, **caractérisé en ce que**
l'agencement (59) de l'élément de résistance (17) sur le support de circuit (21) fait partie de l'ajustement (65) de la valeur de résistance (R), un élément de résistance (17) ayant une valeur de résistance (R) correspondant aux propriétés enregistrées de la diode électroluminescente (15) étant sélectionné et agencé sur le support de circuit (21) afin d'ajuster (65) la valeur de résistance (R).

4. Procédé (51) selon l'une quelconque des revendications précédentes, **caractérisé en ce que**
ladite au moins une diode électroluminescente à montage en surface (15) est collée ou vissée sur le dissipateur thermique (24).

5. Procédé (51) selon l'une quelconque des revendications précédentes, **caractérisé en ce que**
la connexion électrique (28) entre le support de circuit (21) et ladite au moins une diode électroluminescente à montage en surface (15) est créée par soudage, brasage ou grâce à un élément à ressort.

6. Procédé (51) selon l'une quelconque des revendications précédentes, **caractérisé en ce que**
l'élément de résistance (17) comprend une résistance réglable, en particulier une résistance pouvant être réglée par laser (19), la résistance réglable (19) est agencée directement sur le support de circuit (21) et la valeur de résistance (R) de l'élément de résistance (17) est ajustée en corrigeant la valeur de résistance (R) de la résistance réglable (19), en particulier grâce à un ajustement par laser.

7. Procédé (51) selon l'une quelconque des revendications précédentes, **caractérisé en ce que**
l'élément de résistance (17) comprend un réseau de résistances (43) comprenant plusieurs résistances fixes (45 ; 45a à d), les résistances fixes (45 ; 45a à d) sont agencées directement sur le support de circuit (21) et la valeur de résistance (R) de l'élément de résistance (17) est ajustée en pontant au moins un point de connexion (49) du réseau de résistances (43) et/ou en coupant des pontages (47 ; 47a à h) présents dans le réseau de résistances (43).

8. Procédé (51) selon l'une quelconque des revendications précédentes, **caractérisé en ce que**
le support de circuit (21) est une carte de circuit imprimé et l'élément de résistance (17) est agencé sur la carte de circuit imprimé par brasage, en particulier dans le cadre d'un procédé de brasage de CMS (composant monté en surface).

9. Procédé (51) selon l'une quelconque des revendications précédentes, **caractérisé en ce que**
sont saisies en tant que propriétés de la diode électroluminescente (15), des propriétés optiques et/ou électriques, de manière préférée un flux lumineux pouvant être généré au moyen de la diode électroluminescente (15) avec une commande électrique prédéfinie de la diode électroluminescente (15).

10. Procédé (51) selon la revendication 9, **caractérisé en ce que**
lorsque le flux lumineux de la diode électroluminescente (15) est saisi, le flux lumineux est associé à une classe de flux lumineux et la valeur de résistance (R) de l'élément de résistance (17) est ajustée en fonction de la classe de flux lumineux.

11. Agencement de sources lumineuses (13) destiné à un dispositif d'éclairage de véhicule automobile (101), comprenant au moins une diode électroluminescente (15) permettant de produire de la lumière et un élément de résistance (17) permettant de prédéfinir les propriétés optiques et/ou électriques de la diode électroluminescente (15) pour un appareil de commande (31 ; 107) permettant de commander et/ou régler l'agencement de sources lumineuses (13),
**caractérisé en ce que**
la diode électroluminescente (15) est réalisée en tant que diode électroluminescente à montage en surface sous la forme d'une embase comprenant une ou plusieurs puce(s) LED (16) permettant d'émettre de la lumière d'une première longueur d'onde, des connexions électriques (18) sur sa face supérieure et un élément d'étalement thermique (20) occupant toute la surface sur sa face inférieure, la diode électroluminescente à montage en surface (15) étant fixée avec son élément d'étalement thermique (20) directement sur un dissipateur thermique (24), l'élément de résistance (17) étant agencé sur un support de circuit (21) de l'agencement de sources lumineuses (13), une connexion électrique (28) étant créée entre le support de circuit (21) et la diode électroluminescente à montage en surface (15) et une valeur de résistance (R) de l'élément de résistance (17) étant ajustée en fonction de propriétés précédemment saisies de la diode électroluminescente (15).

12. Agencement de sources lumineuses (13) selon la revendication 11, **caractérisé en ce que** l'élément de résistance (17) comprend une résistance réglable (19), en particulier une résistance pouvant être réglée par laser, agencée directement sur le support de circuit (21) et/ou plusieurs résistances fixes (45 ; 45a à d) agencées directement sur le support de circuit (21).

13. Agencement de sources lumineuses (13) selon la revendication 11 ou 12, caractérisé ce que
les connexions électriques (18) sont réalisées sous la forme de pastilles de contact.
